# EUROPEAN PATENT APPLICATION

(11) **EP 2 530 738 A2**
(43) Date of publication of application: **05.12.2012**
(21) Application number: 11759749.2
(22) Date of filing: 24.03.2011
(51) Int. Cl.: H01L 31/042

(54) **SOLAR POWER GENERATING APPARATUS AND METHOD FOR MANUFACTURING SAME**

(30) Priority: 24.03.2010 KR 20100026379
(71) Applicant: LG Innotek Co., Ltd., Seoul 100-714 (KR)
(72) Inventor: JEE, Suk Jae, Seoul 100-714 (KR)
(74) Representative: Novagraaf Technologies
(86) International application number: PCT/KR2011/002045
(87) International publication number: WO 2011/119000

(57) **Abstract**

Disclosed are a solar cell apparatus and a method of fabricating the same. The solar cell apparatus includes a support substrate; first and second back electrodes spaced apart from each other on the support substrate; a light absorbing part on the first back electrode; a first buffer on the light absorbing part; a second buffer on the first buffer; a first barrier layer extending from the first buffer and disposed at a lateral side of the light absorbing part; and a first dummy part extending from the first barrier layer and disposed on a top surface of the second back electrode.

## Description

### Technical Field

The embodiment relates to a solar cell apparatus and a method of fabricating the same.

### Background Art

Recently, as energy consumption is increased, a solar cell has been developed to convert solar energy into electrical energy.

In particular, a CIGS-based solar cell, which is a PN hetero junction apparatus having a substrate structure including a glass substrate, a metallic back electrode layer, a P type CIGS-based light absorbing layer, a high-resistance buffer layer, and an N type window layer, has been extensively used.

### Disclosure

### Technical Problem

The embodiment provides a solar cell apparatus capable of preventing leakage current and improving the photoelectric conversion efficiency.

### Technical Solution

A solar cell apparatus according to the embodiment includes a support substrate; first and second back electrodes spaced apart from each other on the support substrate; a light absorbing part on the first back electrode; a first buffer on the light absorbing part; a second buffer on the first buffer; a first barrier layer extending from the first buffer and disposed at a lateral side of the light absorbing part; and a first dummy part extending from the first barrier layer and disposed on a top surface of the second back electrode.

A solar cell apparatus according to the embodiment includes a support substrate; a back electrode layer on the support substrate; a light absorbing layer formed with a through hole on the back electrode layer; a first buffer layer on a top surface of the light absorbing layer, on an inner wall of the through hole and on a bottom surface of the through hole; a second buffer layer on the first buffer layer; and a window layer on the second buffer layer.

A method of fabricating a solar cell apparatus according to the embodiment includes the steps of forming a back electrode layer on a support substrate; forming a light absorbing layer on the back electrode layer; forming a through hole in the light absorbing layer; forming a first buffer layer on a top surface of the light absorbing layer, on an inner wall of the through hole and on a bottom surface of the through hole; forming a second buffer layer on the first buffer layer; and forming a window layer on the second buffer layer.

### Advantageous Effects

The solar cell apparatus according to the embodiment includes the first barrier layer. The lateral side of the light absorbing part can be insulated by the first barrier layer. Thus, the solar cell apparatus according to the embodiment can prevent current from being leaked through the lateral side of light absorbing part.

In particular, the first barrier layer may be formed by using CdS. Thus, the first barrier layer has high resistance. Therefore, the first barrier layer can effectively prevent the leakage current.

Further, the first dummy part has a thin thickness, so the connection part extending from the window can be readily connected to the second back electrode due to the tunneling effect. That is, since the dummy part has the thin thickness, when the connection part is connected to the second back electrode through the dummy part, the solar cell apparatus according to the embodiment can reduce power loss by the tunneling effect.

In addition, the second barrier layer extending from the second buffer can be disposed at the lateral side of the light absorbing part. Thus, the insulating function for the lateral side of the light absorbing part can be more reinforced by the second barrier layer.

Further, the second barrier layer may have a thickness thicker than a thickness of the second buffer. Thus, the insulating function for the lateral side of the light absorbing part can be more reinforced by the second barrier layer.

Therefore, the solar cell apparatus according to the embodiment can prevent leakage current and improve the power generation efficiency.

### Description of Drawings

FIG. 1 is a plan view showing a solar cell apparatus according to the embodiment;

FIG. 2 is a sectional view taken along line A-A' of FIG. 1;

FIGS. 3 to 6 are sectional views showing a method of fabricating a solar cell apparatus according to the embodiment; and

FIGS. 7 and 8 are sectional views showing a method of fabricating a solar cell apparatus according to another embodiment.

### Best Mode

In the description of the embodiments, it will be understood that when a substrate, a layer, a film or an electrode is referred to as being "on" or "under" another substrate, another layer, another film or another electrode, it can be "directly" or "indirectly" on the other substrate, the other layer, the other film, or the other electrode, or one or more intervening layers may also be present. Such a position of the layer has been described with reference to the drawings. The size of the elements shown in the drawings may be exaggerated for the purpose of explanation and may not utterly reflect the actual size.

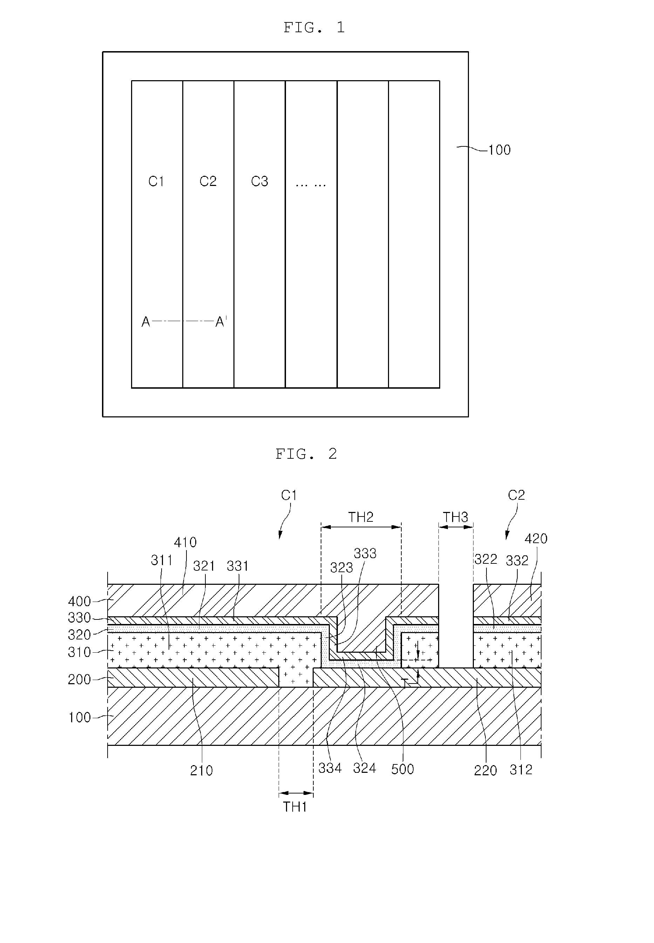

FIG. 1 is a plan view showing a solar cell apparatus according to the embodiment, and FIG. 2 is a sectional view taken along line A-A' of FIG. 1.

Referring to FIGS. 1 and 2, the solar cell apparatus according to the embodiment includes a support substrate 100, a back electrode layer 200, a light absorbing layer 310, a lower buffer layer 320, an upper buffer layer 330, a first barrier 323, a window layer 400 and a connection part 500.

The support substrate 100 has a plate shape and supports the back electrode layer 200, the light absorbing layer 310, the lower buffer layer 320, the upper buffer layer 330, the window layer 400 and the connection part 500. The support substrate 100 may be an insulator. The support substrate 100 may be a glass substrate, a plastic substrate or a metallic substrate. In detail, the support substrate 100 may be a soda lime glass substrate. The support substrate 100 may be transparent. The support substrate 100 may be flexible or rigid.

The back electrode layer 200 is provided on the support substrate 100. The back electrode layer 200 is a conductive layer. For instance, the back electrode layer 200 may include a metal, such as molybdenum (Mo).

In addition, the back electrode layer 200 may include at least two layers. In this case, the layers may be formed by using the same metal or different metals.

A first through hole TH1 is formed in the back electrode layer 200. The first through hole TH1 serves as an open region to expose the top surface of the support substrate 100. When viewed from the top, the first through hole TH1 extends in one direction.

The first through hole TH1 may have a width in the range of about 80µm to about 200µm.

The back electrode layer 200 is divided into a plurality of back electrodes 210, 220....and N by the first through hole TH1. That is, the back electrodes 210, 220...and N are defined by the first through hole TH1. Among the back electrodes 210, 220...and N, only first and second back electrodes 210 and 220 are shown in FIG. 2.

The back electrodes 210, 220....and N are spaced apart from each other by the first through hole TH1. The back electrodes 210, 220....and N are arranged in the form of a stripe.

In addition, the back electrodes 210, 220....and N can be arranged in the form of a matrix. When viewed from the top, the first through hole TH1 can be arranged in the form of a lattice.

The light absorbing layer 310 is disposed on the back electrode layer 200. In addition, materials included in the light absorbing layer 310 are filled in the first through hole TH1.

The light absorbing layer 310 may include group I-III-VI compounds. For instance, the light absorbing layer 310 may include the Cu(In,Ga)Se₂ (CIGS) crystal structure, the Cu(In)Se₂ crystal structure, or the Cu(Ga)Se₂ crystal structure.

The light absorbing layer 310 has an energy bandgap in the range of about 1eV to about 1.8eV.

A second through hole TH2 is formed in the light absorbing layer 310. The second through hole TH2 is formed through the light absorbing layer 310. The second through hole TH2 serves as an open region to expose the top surface of the back electrode layer 200.

The second through hole TH2 is adjacent to the first through hole TH1. That is, when viewed from the top, a part of the second through hole TH2 is located besides the first through hole TH1.

The second through hole TH2 may have a width in the range of about 80µm to about 200µm.

A plurality of light absorbing parts 311, 312...and N are defined in the light absorbing layer 310 by the second through hole TH2. That is, the light absorbing layer 310 is divided into the light absorbing parts 311, 312...and N by the second through hole TH2.

The lower buffer layer 320 is formed on the light absorbing layer 310 and in the second through hole TH2. The lower buffer layer 320 may include CdS and have an energy bandgap in the range of about 2.2eV to about 2.4eV. The lower buffer layer 320 has high resistance. For instance, the resistance of the lower buffer layer 320 is higher than that of the upper buffer layer 330 and the window layer 400.

The upper buffer layer 330 is disposed on the lower buffer layer 320. In addition, the upper buffer layer 330 is disposed in the second through hole TH2. The upper buffer layer 330 may include Ga-doped ZnO or Ga-doped SnO. The upper buffer layer 330 may have an energy bandgap in the range of about 3.1eV to about 3.3eV.

In addition, the upper buffer layer may i-ZnO, which is not doped with impurities.

Thus, the upper buffer layer 330 has very low resistance. For instance, the upper buffer layer 330 may have resistance corresponding to or lower than that of the window layer 400.

The window layer 400 is formed on the upper buffer layer 330. The window layer 400 is a transparent conductive layer. The window layer 400, for instance, may include Al-doped ZnO (AZO).

A third through hole TH3 is formed in the lower upper layer 320, the upper buffer layer 330 and the window layer 400. The third through hole TH3 serves as an open region to expose the top surface of the back electrode layer 200. For instance, the third through hole TH3 may have a width in the range of about 80µm to about 200µm.

The third through hole TH3 is adjacent to the second through hole TH2. In detail, the third through hole TH3 is disposed next to the second through hole TH2. That is, when viewed from the top, the third through hole TH3 is disposed next to the second through hole TH2 in parallel to the second through hole TH2.

The lower buffer layer 320 is divided into a plurality of lower buffers 321, 322....and N, a first barrier layer 323 and a first dummy part 324.

In the same manner, the upper buffer layer 330 is divided into a plurality of upper buffers 331, 332....and N, a second barrier layer 333 and a second dummy part 334.

The first barrier layer 323 extends from the first lower buffer 321 formed on the first light absorbing part 311 and is disposed at a lateral side of the first light absorbing part 311. The first barrier layer 323 is integrally formed with a first lower buffer 321 and interposed between the lateral side of the first light absorbing part 311 and the second barrier layer 333.

The first dummy part 324 extends from the first barrier layer 323 along the top surface of the back electrode layer 200. In detail, the first dummy part 324 extends from the barrier layer and makes contact with the top surface of the second back electrode 220. The first dummy part 324 is integrally formed with the first barrier layer 323. The first dummy part 324 covers the whole area of the bottom surface of the second through hole TH2.

The second barrier layer 333 extends from the first upper buffer 331 formed on the first lower buffer 321 and is disposed on the first barrier layer 323. The second barrier layer 333 is integrally formed with the first upper buffer 321 and interposed between the first barrier layer 323 and the connection part 500.

Similar to the first upper buffer 331, the second barrier layer 333 has low resistance.

The second dummy part 334 extends from the second barrier layer 333 along the top surface of the back electrode layer 200. In detail, the second dummy part 334 extends from the second barrier layer 333 and makes contact with the top surface of the first dummy part 324. The second dummy part 334 is integrally formed with the second barrier layer 333.

The first barrier layer 323 extends from the lower buffers 321, 322....and N and is disposed at the lateral side of the light absorbing parts 311, 312....and N. In the similar way, the second barrier layers 333 extends from the upper buffers 331, 332....and N and is disposed at the lateral side of the light absorbing parts 311, 312....and N.

The first dummy part 324 extends from the first barrier layer 323 along the top surface of the back electrode layer 200. In addition, the second dummy part 334 extends from the second barrier layer 333 and is disposed on the first dummy part 324. The first dummy part 324 covers the whole area of the bottom surface of the second through hole TH2. The first dummy part 324 has a thin thickness. For instance, the first dummy part 324 may have a thickness T in the range of about 1nm to about 80nm. In detail, the first dummy part 324 may have a thickness in the range of about 1nm to about 30nm.

In addition, the window layer 400 is divided into a plurality of windows 410, 420...and N by the third through hole TH3. That is, the windows 410, 420...and N may be defined by the third through hole TH3.

The windows 410, 420...and N may have shapes corresponding to the shapes of the back electrodes 210, 220...and N. That is, the windows 410, 420...and N are arranged in the form of a stripe. In addition, the windows 410, 420...and N can be arranged in the form of a matrix.

In addition, a plurality of cells C1, C2....and Cn are defined by the third through hole TH3. In detail, the cells C1, C2....and Cn are defined by the second and third through holes TH2 and TH3. That is, the solar cell apparatus according to the embodiment can be divided into the cells C1, C2....and Cn by the second and third through holes TH2 and TH3.

In other words, the solar cell apparatus according to the embodiment includes a plurality of cells C1, C2....and Cn. For instance, the solar cell apparatus according to the embodiment includes first and second cells C1 and C2 disposed on the support substrate 100.

The first cell C1 includes the first back electrode layer 210, the first light absorbing part 311, the first lower buffer 321, the first upper buffer 331 and the first window 410.

The first back electrode 210 is disposed on the support substrate 100, and the first light absorbing part 311, the first lower buffer 321, and the first upper buffer 331 are sequentially laminated on the back electrode 210. The first window 410 is disposed on the first upper buffer 331.

That is, the first back electrode 210 faces the first window 410 while interposing the first light absorbing part 311 therebetween.

Although not shown in the drawings, the first upper buffer 331 and the first window 410 covers the first back electrode 210 such that a part of the top surface of the first back electrode 210 can be exposed.

The second cell C2 is disposed on the support substrate 100 in adjacent to the first cell C1. The second cell C1 includes the second back electrode layer 230, the second light absorbing part 312, the second lower buffer 322, the second upper buffer 332 and the second window 420.

The second back electrode 220 is disposed on the support substrate 100 while being spaced apart from the first back electrode 210. The second light absorbing part 312 is disposed on the second back electrode 220 while being spaced apart from the first light absorbing part 311. The second window 420 is disposed on the second upper buffer 332 while being spaced apart from the first window 410.

The second light absorbing part 312 and the second window 420 cover the second back electrode 220 such that a part of the top surface of the second back electrode 220 can be exposed.

In addition, the connection part 500 is disposed in the second through hole TH2. Further, the connection part 500 is disposed on the first dummy part 324.

The connection part 500 extends downward from the window layer 400 and is connected to the back electrode layer 200. For instance, the connection part 500 extends downward from the first window 410 and is connected to the second back electrode 220.

At this time, since the connection part 500, the second dummy part 334 and the second back electrode 220 have low resistance and the first dummy part 324 has a thin thickness, the tunneling effect may occur between the second dummy part 334 and the second back electrode 220. Thus, the current may readily flow between the second dummy part 334 and the second back electrode 220.

Therefore, the connection part 500 can easily connect the window with the back electrode included in adjacent cells C1, C2...and Cn. For instance, the connection part 500 can easily connect the first window 410 with the second back electrode 220.

The connection part 500 is integrally formed with the windows 410, 420...and N. That is, the material for fabricating the connection part 500 is equal to the material for fabricating the window layer 400.

The first barrier layer 323 insulates the lateral sides of the light absorbing parts 311, 312...and N. That is, the first barrier layer 323 is interposed between the light absorbing parts 311, 312...and N and the connection part 500. Thus, the first barrier layer 323 can prevent the leakage current from the lateral sides of the light absorbing parts 311, 312...and N. For instance, the first barrier layer 323 can prevent the current from being leaked to the first back electrode layer 210 through the connection part 500 and the lateral side of the first light absorbing part 311.

That is, since the first barrier layer 323 is interposed between the light absorbing parts 311, 312...and N having the high resistance and the second barrier layer 333 having the low resistance, the tunneling effect may not occur at the first barrier layer 323. Thus, the first barrier layer may increase the resistance at the lateral sides of the light absorbing parts 311, 312...and N.

In addition, it is not necessary to increase the width of the first through hole TH1 in order to prevent the leakage current. In detail, the leakage current can be effectively blocked by the first barrier layer 323 even if the width of the first through hole TH1 is reduced.

Therefore, the width of the first through hole TH1 can be reduced, so the solar cell apparatus according to the embodiment can reduce the dead zone where the power production is impossible.

In addition, since the first dummy part 324 has a thin thickness, the first dummy part 324 may not deteriorate the connection characteristic between the connection part 500 and the back electrode layer 200. For instance, since the first dummy part 324 has the thickness of about 80nm or below, the first dummy part 324 may not increase the resistance between the connection part 500 and the back electrode layer 200.

Therefore, the solar cell apparatus according to the embodiment can improve the connection characteristic between the cells as well as the power generation efficiency.

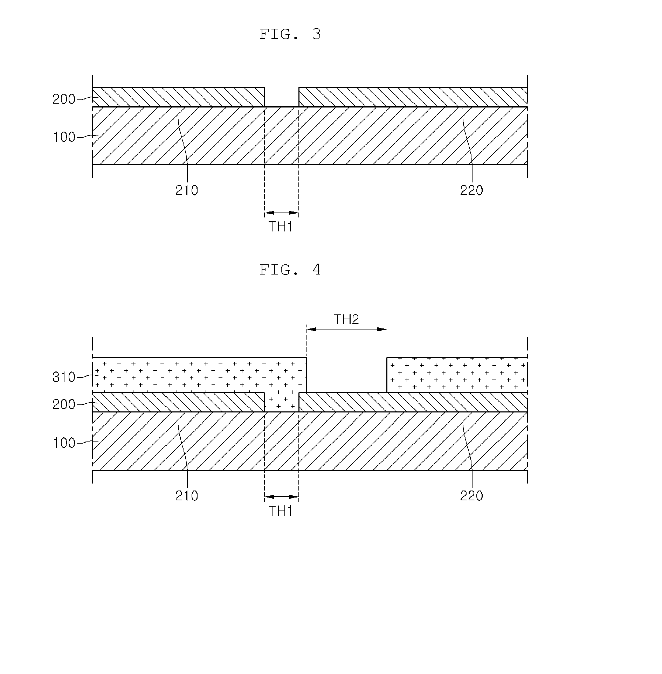

FIGS. 3 to 6 are sectional views showing the method of fabricating the solar cell apparatus according to the embodiment. The above description about the solar cell apparatus will be incorporated herein by reference.

Referring to FIG. 3, the back electrode layer 200 is formed on the support substrate 100. The back electrode layer 200 is patterned to form the first through hole TH1. Thus, a plurality of back electrodes 210, 220...and N are formed on the substrate. The back electrode layer 200 is patterned by a laser.

The first through hole TH1 exposes the top surface of the support substrate 100 and has a width in the range of about 80µm to about 200µm.

In addition, an additional layer, such as a diffusion barrier layer, may be interposed between the support substrate 100 and the back electrode layer 200. At this time, the first through hole TH1 exposes the top surface of the additional layer.

Referring to FIG. 4, the light absorbing layer 310 is formed on the back electrode layer 200.

The light absorbing layer 310 can be formed through the sputtering scheme or the evaporation scheme.

For instance, the light absorbing layer 310 may be formed through various schemes such as a scheme of forming a Cu(In,Ga)Se₂ (CIGS) based light absorbing layer 310 by simultaneously or separately evaporating Cu, In, Ga, and Se and a scheme of performing a selenization process after a metallic precursor layer has been formed

Regarding the details of the selenization process after the formation of the metallic precursor layer, the metallic precursor layer is formed on the back electrode layer 200 through a sputtering process employing a Cu target, an In target, or a Ga target.

Thereafter, the metallic precursor layer is subject to the selenization process so that the Cu (In, Ga) Se₂ (CIGS) based light absorbing layer 310 is formed.

In addition, the sputtering process employing the Cu target, the In target, and the Ga target and the selenization process may be simultaneously performed.

Further, a CIS or a CIG based light absorbing layer 310 may be formed through the sputtering process employing only Cu and In targets or only Cu and Ga targets and the selenization process.

Then, a part of the light absorbing layer 310 is removed to form the second through hole TH2.

The second through hole TH2 can be formed by a mechanical device, such as a tip, or a laser device.

For instance, the light absorbing layer 310 and the lower buffer layer 320 may be patterned by using the tip having a width in the range of about 40µm to about 180µm. In addition, the second through hole TH2 can be formed by using the laser having the wavelength in the range of about 200nm to about 600nm.

At this time, the second through hole TH2 may have a width in the range of about 100µm to about 200µm. In addition, the second through hole TH2 may expose a part of the top surface of the back electrode layer 200.

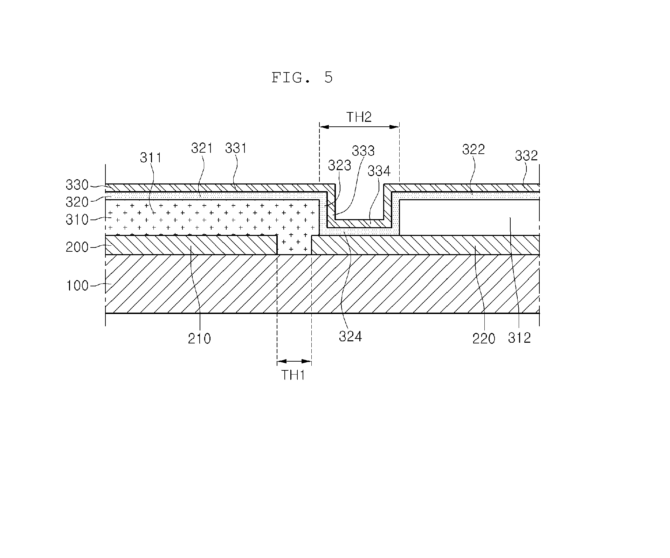

Referring to FIG. 5, CdS is deposited on the light absorbing layer 310 and in the second through hole TH2 through the sputtering scheme or the chemical bath deposition (CBD), so that the lower buffer layer 320 is formed.

After that, ZnO is deposited on the lower buffer layer 320 through the sputtering scheme so that the upper buffer layer 330 is formed.

The lower buffer layer 320 has the thin thickness. For instance, the lower buffer layer 320 has the thickness in the range of about 1nm to abut 80nm.

In addition, the deposition direction of the lower buffer layer 320 and the upper buffer layer 330 may be inclined.

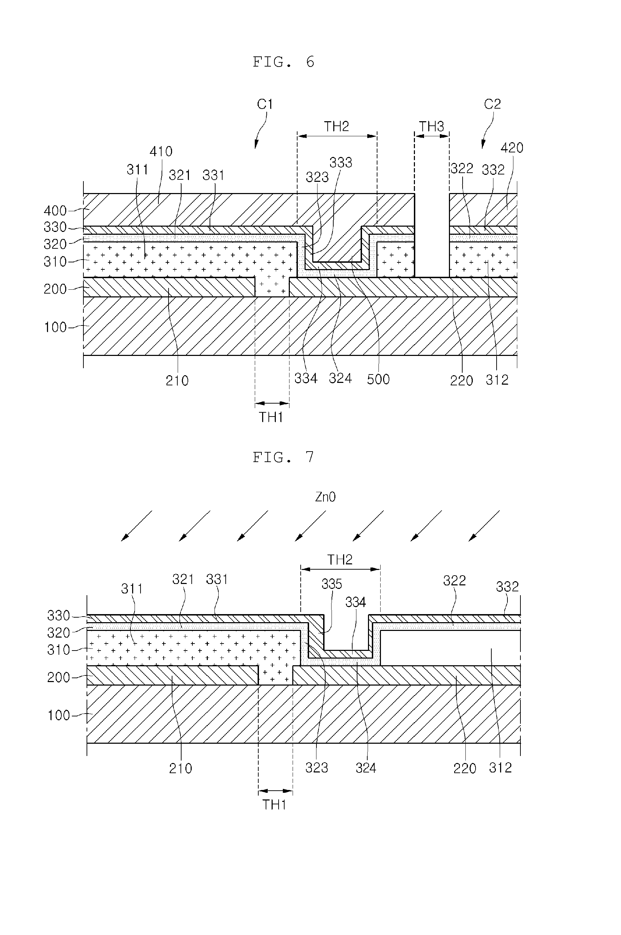

Referring to FIG. 6, the window layer 400 is formed on the upper buffer layer 330. At this time, a material used to form the window layer 400 is filled in the second through hole TH2.

In order to form the window layer 400, a transparent conductive material is deposited on the upper buffer layer 330. The transparent conductive material is fully filled in the second through hole TH2. The transparent conductive material may include Al-doped zinc oxide (AZO).

Thus, the connection part 500, which extends from the window layer 400 and directly makes contact with the back electrode layer 200, is formed in the second through hole TH2.

After that, the lower buffer layer 320, the upper buffer layer 330 and the window layer 400 are partially removed to form the third through hole TH3.

As a result, the first barrier layer 323 is formed at the lateral sides of the light absorbing parts 311, 312...and N and the first dummy part 324 is formed on the back electrode layer 200.

Then, the lower buffer layer 320 and the upper buffer layer 330 are patterned, so that a plurality of lower buffers 321, 322...and N and a plurality of upper buffers 331, 332...and N are sequentially formed on the light absorbing parts 311, 312...and N. In addition, the first and second barrier layers 323 and 333 are formed at the lateral sides of the light absorbing parts 311, 312...and N. Further, the first and second dummy parts 324 and 334 are formed on the bottom surface of the second through hole TH2.

In addition, the window layer 400 is patterned to define a plurality O f windows 410, 420...and N and a plurality of cells C1, C1...and Cn.

The third through hole TH3 may have a width in the range of about 80µm to about 200µm.

In this manner, the solar cell apparatus having the high efficiency can be fabricated by forming the first and second barrier layers 323 and 333.

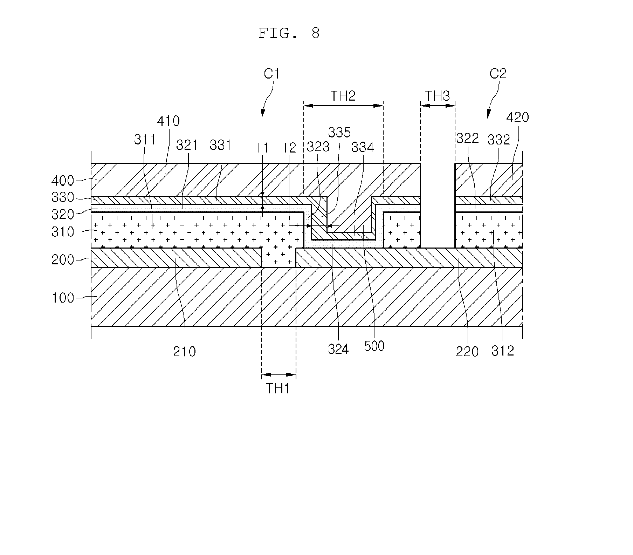

FIGS. 7 and 8 are sectional views showing the method of fabricating the solar cell apparatus according to another embodiment. The above description about the solar cell apparatus and the method of fabricating the same will be incorporated herein by reference. That is, the above description about the solar cell apparatus and the method of fabricating the same will be incorporated herein except for changed parts.

Referring to FIG. 7, CdS is deposited on the top surface of the light absorbing layer 310, on the inner wall of the second through hole TH2 and on the bottom surface of the second through hole TH2 through the sputtering scheme or the CBD scheme to form the lower buffer layer 320.

Then, Ga-doped zinc oxide, Ga-doped tin oxide or i-zinc oxide, which is not doped with impurities, is deposited on the lower buffer layer 320 to form the upper buffer layer 330.

At this time, the deposition direction of the material, which is deposited on the lower buffer layer 430 to form the upper buffer layer 330, may be inclined with respect to the support substrate 100. For instance, the deposition direction of the material to form the upper buffer layer 330 may be inclined with respect to the support substrate 100 at an angle of about 10° to about 40°.

Thus, the second barrier layer 335 may have a thick thickness T2. That is, the thickness T2 of the second barrier layer 335 may be thicker than the thickness T1 of upper buffer layers 331 and 332 formed on the top surface of the light absorbing layer 310. In other words, the thickness T1 of upper buffer layers 331 and 332 formed on the top surface of the light absorbing layer 310 may be thinner than the thickness T2 of the upper buffer layer 335 formed at the lateral side of the light absorbing part 311.

Referring to FIG. 8, the window layer 400 and the third through hole TH3 are formed on the upper buffer layer 330.

The solar cell apparatus according to the present embodiment includes the second barrier layer 335 having the relatively thick thickness. Thus, the insulation function for the lateral side of the light absorbing part 311 can be more reinforced.

Thus, the solar cell apparatus according to the present embodiment can improve the connection characteristic between the cells while enhancing the power generation efficiency.

Any reference in this specification to "one embodiment," "an embodiment," "example embodiment," etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effects such feature, structure, or characteristic in connection with other ones of the embodiments.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

### Industrial applicability

The solar cell apparatus according to the embodiment can be applied in the field of solar light generation.

## Claims

1. A solar cell apparatus comprising:
a support substrate;
first and second back electrodes spaced apart from each other on the support substrate;
a light absorbing part on the first back electrode;
a first buffer on the light absorbing part;
a second buffer on the first buffer;
a first barrier layer extending from the first buffer and disposed at a lateral side of the light absorbing part; and
a first dummy part extending from the first barrier layer and disposed on a top surface of the second back electrode.

2. The solar cell apparatus of claim 1, further comprising:
a window on the second buffer; and
a connection part extending from the window and connected to the second back electrode,
wherein the first barrier layer is interposed between the light absorbing part and the connection part.

3. The solar cell apparatus of claim 1, wherein the first dummy part has a thickness in a range of 1nm to 80nm.

4. The solar cell apparatus of claim 1, further comprising:
a second barrier layer extending from the second buffer and disposed at the lateral side of the light absorbing layer; and
a second dummy part extending from the second barrier layer and disposed on the first dummy part.

5. The solar cell apparatus of claim 4, wherein a thickness of the second barrier layer is thicker than a thickness of the second buffer.

6. The solar cell apparatus of claim 4, wherein the first buffer, the first barrier layer and the first dummy part are integrally formed with each other, and the second buffer, the second barrier layer and the second dummy part are integrally formed with each other.

7. The solar cell apparatus of claim 4, wherein the first barrier layer includes CdS, and the second barrier layer includes Ga-doped tin oxide.

8. The solar cell apparatus of claim 4, wherein the first barrier layer includes CdS, and the second barrier layer includes i-ZnO, which is not doped with impurities.

9. A solar cell apparatus comprising:
a support substrate;
a back electrode layer on the support substrate;
a light absorbing layer having a through hole on the back electrode layer;
a first buffer layer on a top surface of the light absorbing layer, on an inner wall of the through hole and on a bottom surface of the through hole;
a second buffer layer on the first buffer layer; and
a window layer on the second buffer layer.

10. The solar cell apparatus of claim 9, wherein the first buffer layer covers an entire area of the bottom surface of the through hole.

11. The solar cell apparatus of claim 9, wherein the first buffer layer formed on the bottom surface of the through hole has a thickness in a range of 1nm to 80nm.

12. The solar cell apparatus of claim 9, wherein the second buffer layer includes Ga-doped tin oxide.

13. The solar cell apparatus of claim 9, wherein a thickness of the second buffer layer formed on the inner wall of the through hole is thicker than a thickness of the second buffer layer formed on the light absorbing layer.

14. A method of fabricating a solar cell apparatus, the method comprising:
forming a back electrode layer on a support substrate;
forming a light absorbing layer on the back electrode layer;
forming a through hole in the light absorbing layer;
forming a first buffer layer on a top surface of the light absorbing layer, on an inner wall of the through hole and on a bottom surface of the through hole;
forming a second buffer layer on the first buffer layer; and
forming a window layer on the second buffer layer.

15. The method of claim 14, wherein, in the forming of the through hole, the light absorbing layer is patterned by using a mechanical device or a laser such that a part of the back electrode layer is exposed.

16. The method of claim 15, wherein, in the forming of the second buffer layer, a material to form the second buffer layer is deposited in a direction inclined with respect to the support substrate.

17. The method of claim 16, wherein, in the forming of the second buffer layer, i-ZnO, which is not doped with impurities, or Ga-doped tin oxide is deposited on the first buffer layer in a direction inclined with respect to the support substrate.
